# EUROPEAN PATENT APPLICATION

(11) **EP 4 848 329 A1**
(43) Date of publication of application: **02.12.2026**
(21) Application number: 26177480.6
(22) Date of filing: 08.05.2026
(51) Int. Cl.: H01J 37/32, C23C 16/44, C23C 16/455, C23C 16/458, C30B 25/14, H10P 72/00

(54) **LINER FOR VERTICAL FURNACE**

(30) Priority: 13.05.2025 US 202563804993 P
(71) Applicant: ASM IP Holding B.V., 1322 AP Almere (NL)
(72) Inventor: YUKANANTO, Riza, 1322 AP Almere (NL); TERHORST, Herbert, 1322 AP Almere (NL); BANKRAS, Radko Gerard, 1322 AP Almere (NL); OOSTERLAKEN, Theodorus G.M., 1322 AP Almere (NL); JDIRA, Lucian, 1322 AP Almere (NL)
(74) Representative: V.O.

(57) **Abstract**

A liner for a process chamber of a batch semiconductor processing apparatus is disclosed. The liner comprises a liner wall extending between a closed upper end and an open lower end adapted for receiving a substrate boat. The liner wall comprises an opening extending between the upper end and the lower end.

## Description

### FIELD

The present disclosure relates generally to the field of semiconductor processing methods, and associated structures and apparatus, and to the field of device and integrated circuit manufacture. More particularly the present disclosure generally relates to a liner for a batch semiconductor processing apparatus, for example a vertical furnace.

### BACKGROUND

Liners are commonly utilized in batch semiconductor processing systems, such as vertical furnaces, due to their functional benefits. Typically, a liner is positioned between a wafer boat and the process tube within the semiconductor processing apparatus. Use of a liner is advantageous because the liner may be more quickly and easily removed, cleaned, or replaced as compared to the process tube itself, thereby significantly reducing operational downtime. The liner may serve a protective function by shielding the process tube's interior surfaces from the corrosive effects of process gases used during layer deposition on wafers. This protective action can help in prolonging the lifespan of the highly expensive process tube, making it a cost-effective solution in maintaining the integrity and functionality of the semiconductor equipment.

In cross-flow reactor configurations, the liner may comprise a series of outlet holes spaced apart along a vertical axis of the liner. The volume outside the liner may be connected to a vacuum line, allowing for gas to be extracted from the inner volume of the liner through the series of outlet holes.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a liner for a process chamber of a batch semiconductor processing apparatus, the liner comprising a liner wall extending between a closed upper end and an open lower end adapted for receiving a substrate boat. The liner wall comprises an opening extending between the upper end and the lower end.

The liner allows for a volume around the edge of substrates contained in the substrate boat to be reduced, which may cause a greater quantity of process gas to be forced between the substrates for deposition on surfaces of the substrates. This can result in improved process efficiency and uniformity of deposited layers. The opening extending between the upper end and the lower end allows for placement of multiple exhaust outlets in the opening, each of which may be connected to a separate vacuum pump, thereby allowing for tailoring of the exhaust characteristics.

Thus the liner according to embodiments of the present invention provides at the same time the advantages of a reduced volume around the edge of the substrates, and the advantages of compatibility with gas extraction from the inner volume of the liner via multiple exhaust outlets.

The opening may extend over at least 75% of a height of the liner between the upper end and the lower end.

The opening may extend to the lower end of the liner.

The liner wall may comprise a single opening extending between the upper end and the lower end.

The liner wall may comprise two openings extending between the upper end and the lower end and spaced apart in a direction around a circumference of the liner. The liner may comprise a support rib in the opening extending between the upper end and the lower end and delimiting the two openings. This may allow for greater mechanical stability of the liner.

The opening may have straight sides in a direction along a central axis of the liner. The straight sides may be substantially parallel to each other.

The liner may have a central axis along a direction in which the upper end and the lower end are spaced apart, and the opening may subtend an angle at the central axis in a plane perpendicular to the central axis, the angle being between 20 degrees and 90 degrees.

The liner wall may be tapered at the top end. This may allow for improved fit into a process chamber.

The liner may comprise a bulge extending between the lower end and the upper end and positioned opposite to the opening. The bulge may be configured for accommodating at least one gas injector. By providing the bulge in the liner, space may be provided for gas injectors inside the liner while still providing the advantage of a reduced liner diameter at positions away from the bulge, allowing a volume around the edge of the substrates to be reduced.

The bulge may subtend an angle at the central axis in a plane perpendicular to the central axis which is between 30 degrees and 120 degrees.

The liner may have a radius at the bulge which is greater than a radius at a position located away from the bulge and the opening.

The radius at the bulge may be between 10% and 30% larger than the radius at a position located away from the bulge and the opening.

The liner may comprise silicon carbide, silicon, or quartz.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a schematic cross-sectional view of a batch semiconductor processing apparatus in which a liner according to embodiments of the present invention may be comprised;
FIG. 2 is a schematic perspective view of a liner according to embodiments of the present invention comprising an opening extending to a lower end of the liner, and a bulge;
FIG. 3 is a cross-sectional view of a liner according to embodiments of the present invention, taken in a plane perpendicular to the central axis A of the liner, illustrating angles subtended by the opening and by the bulge at the central axis;
FIG. 4 is a cross-sectional view of a liner according to embodiments of the present invention, taken in a plane perpendicular to the central axis A of the liner, illustrating differing radii of the liner at the bulge and away from the bulge;
FIG. 5 is a cross-sectional view of a liner according to embodiments of the present invention, taken in a plane perpendicular to the central axis A of the liner, shown with injectors accommodated in the bulge and gas exhaust conduits disposed adjacent to the opening;
FIG. 6 is a schematic perspective view of a liner according to embodiments of the present invention comprising an opening which does not completely extend to a lower end of the liner, and a bulge;
FIG. 7 is a schematic perspective view of a liner according to embodiments of the present invention comprising two openings, and a bulge;
FIG. 8 is a cross-sectional view of the liner of FIG. 2, taken in a plane parallel to and including the central axis A;
FIG. 9 is a schematic perspective view of a pair of gas exhaust conduits which may be positioned adjacent to the opening of the liner according to embodiments of the present invention.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

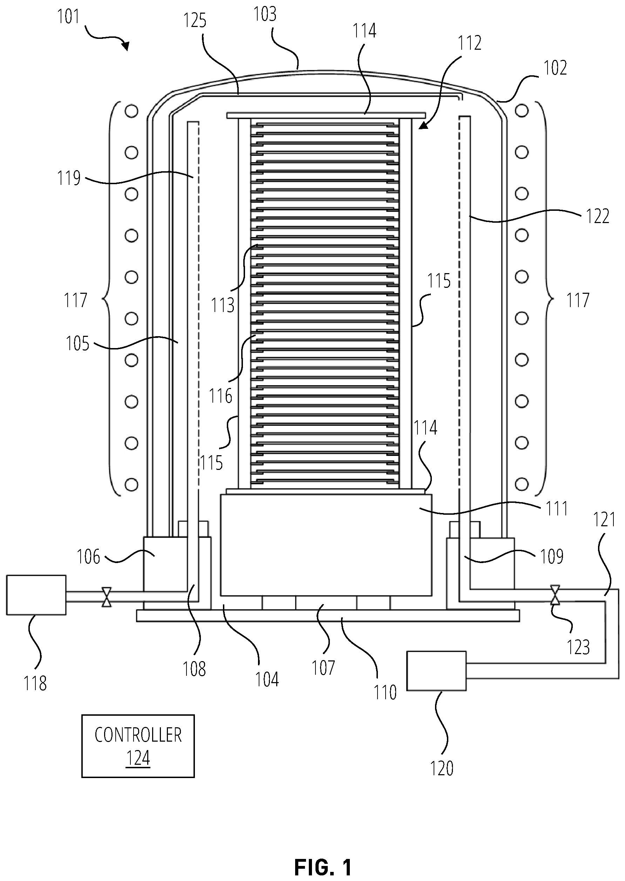

Referring to FIG. 1, a semiconductor processing apparatus in which a liner according to embodiments of the present invention may be included is shown. The semiconductor processing apparatus 101 comprises a process chamber 102 which is generally bell jar shaped, having a closed top end 103, a closable bottom end 104, and an interior space 105. The semiconductor processing apparatus 101 may be a vertical furnace and the process chamber 102 may accordingly extend in a vertical direction between the top end 103 and the bottom end 104. The semiconductor processing apparatus 101 may comprise a flange assembly 106 for at least partially supporting the process chamber 102 at the bottom end 104. The flange assembly 106 may be generally circular in shape as viewed along the vertical direction. The flange assembly 106 may comprise a central opening 107 and various gas inlets 108 and gas outlet 109 for providing or removing a gas from the interior space 105 respectively. The flange assembly 106 may be configured to partially close off the bottom end 104 of the process chamber 102.

The semiconductor processing apparatus 101 may comprise a doorplate 110 configured to at least partially close off the bottom end 104 of the process chamber 102. The doorplate 110 may support a pedestal 111 thereon. The pedestal 111 may be configured to support a substrate carrier 112, also referred to as a boat. In some embodiments, no pedestal may be provided and the substrate carrier 112 may be supported directly on the doorplate 110. The pedestal (if included) and boat may be inserted into and removed from the process chamber 102 through the bottom end 104 by moving the doorplate 110 in a vertical direction.

The substrate carrier 112 is configured to support a plurality of substrates 113 therein. The plurality of substrates 113 may be spaced apart in a vertical direction. The substrate carrier 112 may comprise two end plates 114 spaced apart by a plurality of support rods 115. The plurality of support rods 115 may comprise a plurality of sets of slots 116 or projections for supporting the plurality of substrates 113, each set of slots 116 or projections being spaced apart from the other sets of slots 116 or projections in the vertical direction. Each set of slots 116 or projections being at a same vertical position forms a respective substrate receiving position.

The semiconductor processing apparatus 101 may comprise a heater for heating the process chamber 102 and thereby heating the interior space 105, for example in the form of heating coils 117 disposed around an outer surface of the process chamber 102.

The semiconductor processing apparatus 101 may comprise at least one gas inlet 108 in the flange assembly 106 for providing a gas or gases to the interior space 105 of the process chamber 102. The at least one gas inlet 108 may each be connected to one or more respective gas sources 118. The gas sources 118 may include process gas sources and purge gas sources. The gas inlets 108 may be categorised according to the type of gas to be provided therethrough; for example, the flange assembly 106 may comprise one or more process gas inlets and one or more purge gas inlets.

The semiconductor processing apparatus 101 may comprise at least one injector 119, each in fluid communication with a respective gas inlet 108. The semiconductor processing apparatus 101 may comprise the same number of injectors 119 as gas inlets 108, or may comprise fewer injectors than gas inlets, that is, one or more gas inlets 108 may not be connected to an injector 119. The injector or each of the injectors 119 may extend in a vertical direction within the process chamber 102. In some embodiments, the semiconductor processing apparatus 101 may comprise at least one multi-hole injector and at least one dump injector.

The semiconductor processing apparatus 101 may comprise a plurality of gas outlets 109 in the flange assembly 106 for removing a gas or gases from the interior space 105 of the process chamber 102. The plurality of gas outlets 109 may each be in fluid communication with a vacuum pump 120 via respective exhaust gas lines 121. The semiconductor processing apparatus comprises a plurality of, e.g. two, gas exhaust conduits 122, each in fluid communication with a respective gas outlet 109. The gas exhaust conduit(s) 122 through which gas is exhausted may be selected by opening or closing valves 123 which may be disposed in each of the exhaust gas lines 121. Each of the gas exhaust conduits 122 may be supported at a bottom end by a gas exhaust conduit holder which may be removably attached to the flange assembly 106. Each of the gas exhaust conduits 122 extends in a vertical direction inside the process chamber 102 and comprises a plurality of holes spaced apart in the vertical direction. A hole arrangement of a first set of holes in a first one of the gas exhaust conduits 122 is different to a hole arrangement of a second set of holes in a second one of the gas exhaust conduits 122. Thus a gas extraction profile for the first one of the gas exhaust conduits 122 may be different to a gas extraction profile for the second one of the gas exhaust conduits 122. By providing a pair of gas exhaust conduits 122 each having a different gas extraction profile, due to their differing arrangement of holes, a total gas extraction profile for the pair can be tuned by controlling a relative flow rate of gas through one of the gas exhaust conduits 122 relative to the other, as each gas exhaust conduit is connected to a respective exhaust gas line 121, to which no other gas exhaust conduit is connected.

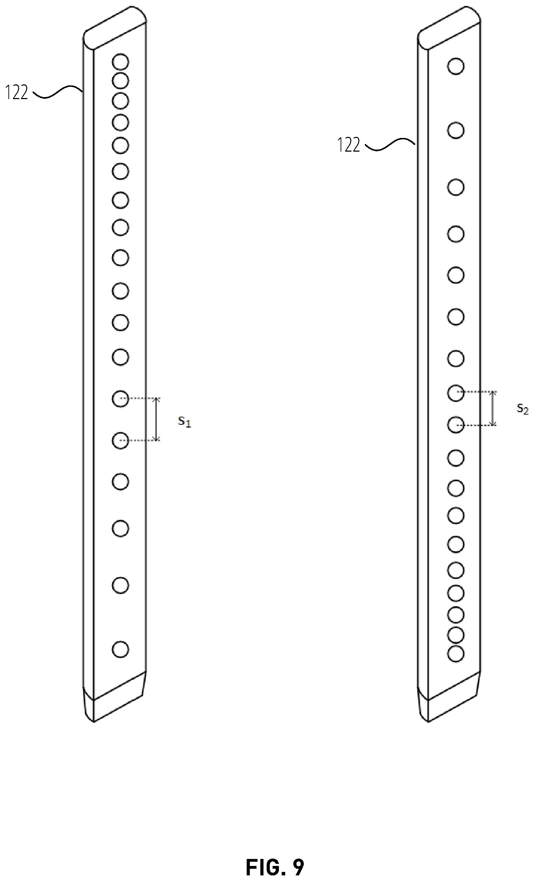

An example of a pair of gas exhaust conduits 122 is shown in FIG. 9, in which a first hole spacing s₁ in a first of the gas exhaust conduits 122 decreases from a bottom end of the first of the gas exhaust conduits 122 to a top end of the first of the gas exhaust conduits 122, and a second hole spacing s₂ in a second of the gas exhaust conduits 122 increases from a bottom end of the second of the gas exhaust conduits 122 to a top end of the second of the gas exhaust conduits 122. The hole arrangement may differ between two gas exhaust conduits 122 by varying size of the holes in the gas exhaust conduits 122, for example a hole size may decrease from a bottom end of the first of the gas exhaust conduits 122 to a top end of the first of the gas exhaust conduits 122, and may increase from a bottom end of the second of the gas exhaust conduits 122 to a top end of the second of the gas exhaust conduits 122. Other hole arrangement variations may be used.

The semiconductor processing apparatus 101 may comprise the same number of gas exhaust conduits 122 as gas outlets 109, or may comprise fewer gas exhaust conduits 122 than gas outlets 109, that is, one or more gas outlets 109 may not be connected to a gas exhaust conduit 122.

The semiconductor processing apparatus 101 may comprise a controller 124 which may be configured to control various elements of the semiconductor processing apparatus 101. The controller 124 may comprise a memory for storing, for example, program instructions, setpoint values, characterisation data, and other data. The controller 124 may comprise a processor for executing program instructions which may be loaded from the memory. The controller 124 may be configured to receive data from sensors in the semiconductor processing apparatus 101, for example pressure sensors, temperature sensors, and/or other types of sensors. The controller 124 may be configured to control elements of the semiconductor processing apparatus 101 by sending control signals to, for example, gas flow control valves, heating elements, water cooling elements.

The semiconductor processing apparatus 101 may comprise a liner 125 according to embodiments of the present invention. The liner 125 may be supported on the flange assembly 106 and may extend vertically in the process chamber 102. The liner 125 may enclose the substrate carrier 112 and the injectors 119. The liner 125 may comprise, for example, silicon carbide, silicon, or quartz.

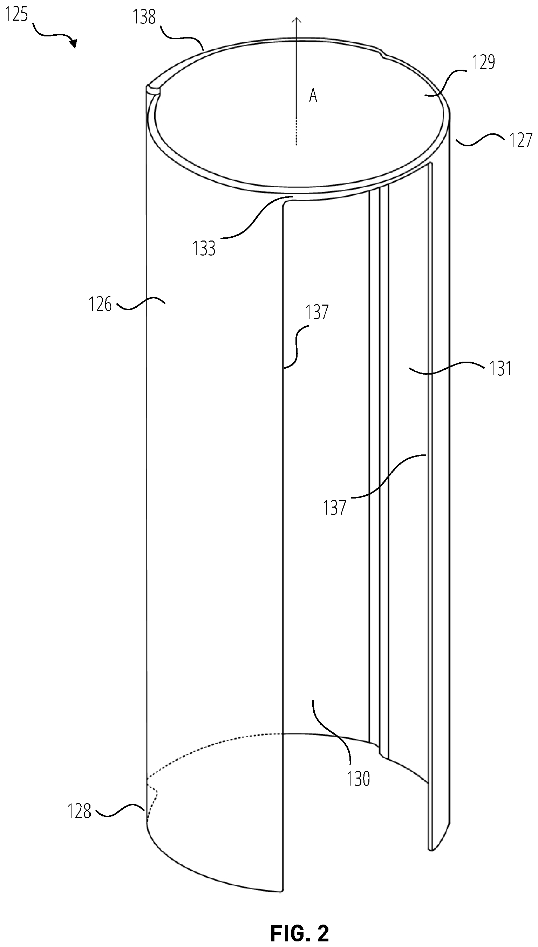

Referring to FIG. 2, the liner 125 is shown in more detail. The liner 125 comprises a liner wall 126 which extends between a closed upper end 127 and an open lower end 128. The upper end 127 may be closed by a top member 129. The liner wall 126 and the top member 129 may be formed monolithically or the top member 129 may be formed separately and attached to the liner wall 126. The liner wall may be tapered at the upper end 127 so as to provide an improved fit in a process chamber. The upper end 127 is closed for gas flow through the upper end 127, e.g. through the top member 129. The lower end 128 is open. The lower end 128 may be shaped so as to receive a wafer boat to be positioned within the liner 125 in an inner volume 130 of the liner 125.

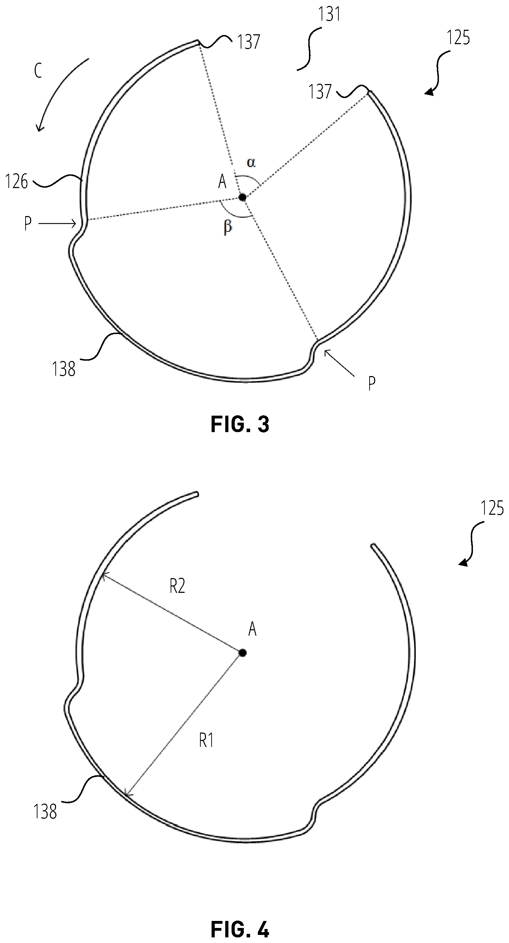

The liner wall 126 may have a generally cylindrical shape with a central axis A extending in a direction in which the upper end 127 and the lower end 128 are spaced apart. Referring to FIG. 3, a circumferential direction C may be defined in a plane perpendicular to the central axis A and being a direction around a circumference of the liner wall 126. The liner wall 126 may have a thickness of, for example, between 3 mm and 6 mm.

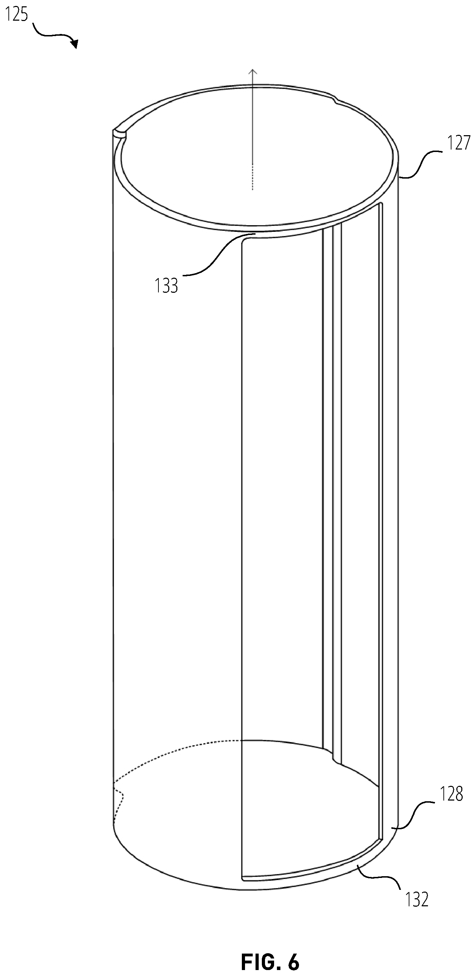

The liner wall 126 comprises an opening 131 which extends between the upper end 127 and the lower end 128. In some embodiments, the opening 131 may extend completely to the lower end 128 such that the liner wall 126 is interrupted in the circumferential direction C at the opening 131 at the lower end 128. Referring to FIG. 6, in some embodiments, the opening 131 may not extend completely to the lower end 128 and the liner wall 126 may be continuous in the circumferential direction C at the lower end 128. In such cases, the liner wall 126 may comprise a lip 132 between the lower end 128 and the opening 131.

In some embodiments, the opening 131 may extend completely to the upper end 127 such that the liner wall 126 is interrupted in the circumferential direction C at the opening at the upper end 127. In some embodiments, the opening 131 may not extend completely to the lower end 128 and the liner wall 126 may be continuous in the circumferential direction C at the upper end 127. In such cases, the liner wall 126 may comprise an overhang 133 between the upper end 127 and the opening 131.

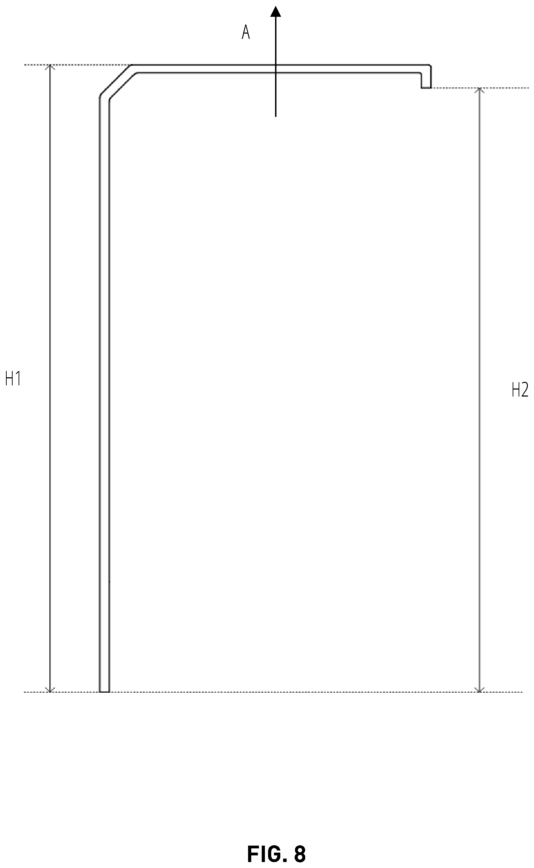

Referring to FIG. 8, the liner 125 may have a height H1 measured from the upper end 127 to the lower end 128 in the direction of the central axis A. The opening 131 may have a height H2 measured in the direction of the central axis A. The height H2 of the opening 131 may be at least 75% of the height H1 of the liner 125. The height H2 of the opening 131 may be at least 80%, at least 85%, at least 90%, or at least 95% of the height H1 of the liner 125. In some embodiments, the height H2 of the opening 131 may be 100% of the height H1 of the liner 125.

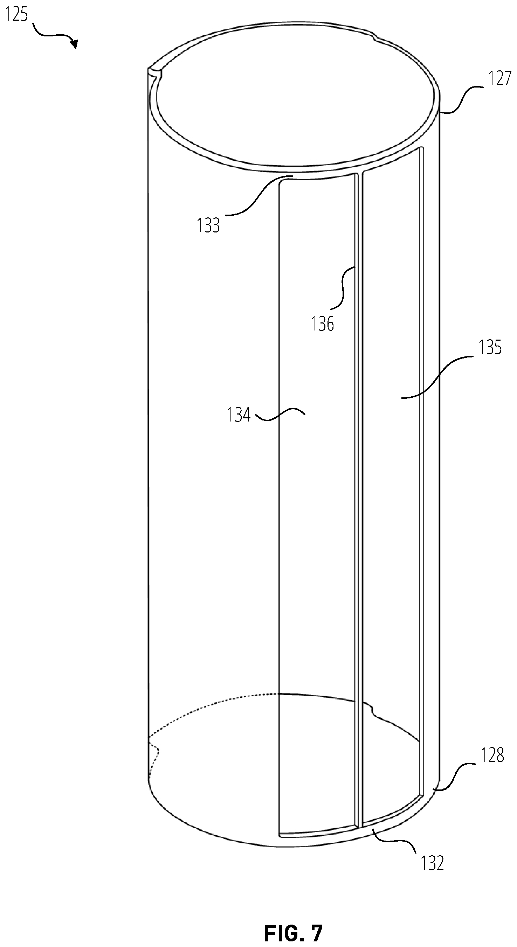

The liner 125 may comprise a single opening 131 extending between the upper end 127 and the lower end 128. In some embodiments, the liner 125 may comprise more than one opening 131, for example two openings, each extending between the upper end 127 and the lower end 128. Referring to FIG. 7, in some embodiments, the liner 125 may comprise a first opening 134 and a second opening 135. The first opening 134 extends between the upper end 127 and the lower end 128. The second opening 135 extends between the upper end 127 and the lower end 128. The first opening 134 is spaced apart from the second opening 135 in the circumferential direction C. The first opening 134 and the second opening 135 may be spaced apart in the circumferential direction by a support rib 136 which may be comprised in the liner wall 126. The support rib 136 may help to provide additional stability to the liner 125. The support rib 136 may extend between the lip 132 and the overhang 133.

The first opening 134 may have a height measured in the direction of the central axis which is at least 75%, at least 80%, at least 90%, or at least 95% of the height H1 of the liner 125. The second opening 135 may have a height measured in the direction of the central axis which is at least 75%, at least 80%, at least 90%, or at least 95% of the height H1 of the liner 125.

The opening 131 or openings 134, 135 may have straight sides 137 in a direction along the central axis A. The straight sides 137 may be substantially parallel to each other. This may allow for a good fit between a shape of the opening or openings and a shape of a gas exhaust conduit to be placed adjacent to the opening or openings.

Referring to FIG. 3, the sides 137 of the opening 131 may subtend an angle α at the central axis A in a plane perpendicular to the central axis A. The angle α may be between 20 degrees and 90 degrees. The angle α may be between 40 degrees and 70 degrees. In embodiments wherein the liner 125 comprises more than one opening 131, the angle α, measured in a plane perpendicular to the central axis A, is the angle subtended by the sides 137 of the openings which are spaced apart by the largest distance. For example, in some embodiments, the liner 125 comprises the first opening 134 and the second opening 135 and the angle α is measured between those sides of the first opening 134 and the second opening 135 which are not located at the support rib 136.

Referring again to FIG. 2, in some embodiments, the liner 125 comprises a bulge extending between the lower end 128 and the upper end 127. The bulge 138 is positioned on an opposite side of the liner 125 to the opening 131 or openings 134, 135.

Referring to FIG. 4, the bulge 138 is a region of the liner wall 126 in which the liner wall 126 has a radius R1 which is greater than a radius R2 at a position located away from the bulge and the opening. The bulge 138 may be configured for accommodating at least one gas injector 119. By providing the bulge 138, space for gas injector(s) may be provided while allowing the radius of the liner wall 126 at positions away from the bulge 138 and the opening 131 to be made smaller, thereby decreasing an annular volume around substrates supported in a substrate carrier which may be positioned in the liner 125. The radius R1 at the bulge 138 may be between 10% and 30% larger than the radius R2 measured at a position away from the bulge 138 and the opening 131.

Referring to FIG. 3, the bulge 138 may subtend an angle β at the central axis A, measured in a plane perpendicular to the central axis A. The angle β may be between 30 degrees and 150 degrees. The angle β may be between 30 degrees and 120 degrees. The angle β may be between 70 degrees and 110 degrees. The angle β may be measured between points P on each side of the bulge 138 at which the radius of the liner wall 126 begins to increase.

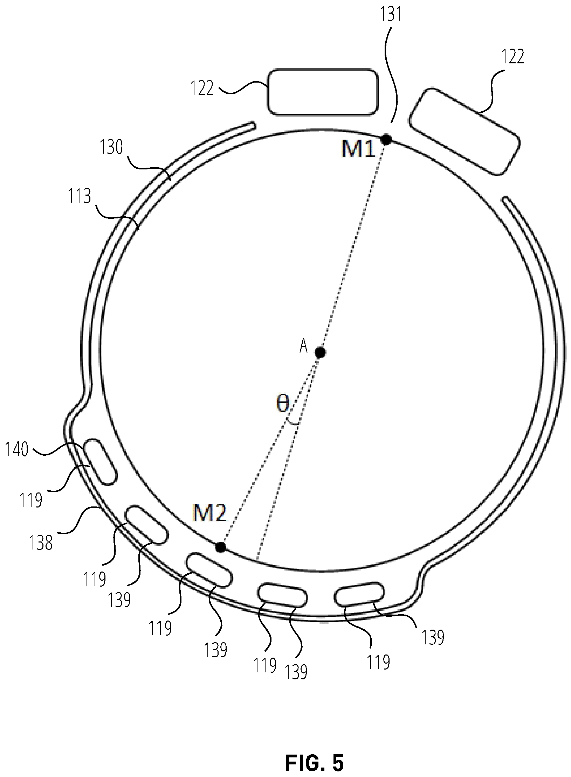

Referring to FIG. 5, an example use of the liner 125 is shown in which five injectors 119 are positioned in the bulge 138 and two gas exhaust conduits 122 are positioned adjacent to the opening 131. The injectors 119 are spaced apart in the circumferential direction. The two gas exhaust conduits 122 are provided slightly outside the liner 125 and spaced apart in the circumferential direction. A substrate 113 is shown in the inner volume 130 of the liner 125. The substrate 113 is supported in a substrate carrier (not shown). In the example of FIG. 5, four of the injectors 119 are multi-hole injectors 139, each having a series of gas outlet holes distributed along their length so as to provide gas into the inner volume 130 at a range of positions along the height of the liner 125. The multi-hole injectors 139 may be used to provide one or more process gases to the inner volume 130 of the liner 125. One injector is a dump injector 140, having a single outlet hole at its top end. The dump injector may be used to provide a purge gas to the inner volume 130 of the liner 125. In some applications, uniformity of flow of a purge gas provided by the dump injector 140 may be less important than uniformity of flow of process gases provided by the multi-hole injectors 139. In order to provide a more symmetrical flow path from the multi-hole injectors 139 to the gas exhaust conduits 122, in some embodiments, a midpoint M1 of the opening 131 in the circumferential direction may not be diametrically opposite a midpoint M1 of the bulge 138 in the circumferential direction but may instead be slightly offset. The degree of offset θ may be, for example, between 5 and 20 degrees from diametrically opposite. The degree of offset θ may be less than 30 degrees from diametrically opposite. In some embodiments, a dump injector 140 may not be used and the midpoint M1 of the opening 131 in the circumferential direction may be substantially diametrically opposite a midpoint M2 of the bulge 138 in the circumferential direction, for example between -5 and +5 degrees from diametrically opposite.

The opening 131 allows for use of the two (or more) gas exhaust conduits 122 without providing a second bulge in the liner, which may cause the liner to not fit into the process chamber, due to the larger size of the gas exhaust conduits 122 compared with the injectors 119. The opening 131 provides a passage for gas from the inner volume 130 to the inlet holes of the gas exhaust conduits 122 (FIG. 9).

In some embodiments, the liner 125 comprises the opening(s) 131 and does not comprise the bulge 138. In such embodiments, injector(s) 119 may be accommodated in the inner volume 130 of the liner 125.

Although illustrative embodiments of the present invention have been described above, in part with reference to the accompanying drawings, it is to be understood that the invention is not limited to these embodiments. Variations to the disclosed embodiments can be understood and effected by those skilled in the art in practicing the claimed invention, from a study of the drawings, the disclosure, and the appended claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A liner for a process chamber of a batch semiconductor processing apparatus, the liner comprising a liner wall extending between a closed upper end and an open lower end adapted for receiving a substrate boat; wherein the liner wall comprises an opening extending between the upper end and the lower end.

2. The liner of claim 1, wherein the opening extends over at least 75% of a height of the liner between the upper end and the lower end.

3. The liner of claim 1 or 2, wherein the opening extends to the lower end of the liner.

4. The liner of any one of claims 1 to 3, wherein the liner wall comprises a single opening extending between the upper end and the lower end.

5. The liner of any one of claims 1 to 3, wherein the liner wall comprises two openings extending between the upper end and the lower end and spaced apart in a direction around a circumference of the liner.

6. The liner of claim 5, comprising a support rib in the opening extending between the upper end and the lower end.

7. The liner of any one of claims 1 to 6, wherein the opening or openings have straight sides in a direction along a central axis of the liner.

8. The liner of claim 7, wherein the straight sides are substantially parallel to each other.

9. The liner of any one of claims 1 to 8, wherein the liner has a central axis along a direction in which the upper end and the lower end are spaced apart, wherein the opening subtends an angle at the central axis in a plane perpendicular to the central axis which is between 20 degrees and 90 degrees.

10. The liner of any one of claims 1 to 9, wherein the liner wall is tapered at the top end.

11. The liner of any one of claims 1 to 10, comprising a bulge extending between the lower end and the upper end and positioned opposite to the opening.

12. The liner of claim 11, wherein the bulge is configured for accommodating at least one gas injector.

13. The liner of claim 11 or 12, wherein the bulge subtends an angle at the central axis in a plane perpendicular to the central axis which is between 30 degrees and 120 degrees.

14. The liner of any one of claims 11 to 13, wherein the liner has a radius at the bulge which is greater than a radius at a position located away from the bulge and the opening.

15. The liner of claim 14, wherein the radius at the bulge is between 10% and 30% larger than the radius at a position located away from the bulge and the opening.

16. The liner of any one of claims 1 to 15, comprising silicon carbide, silicon, or quartz.
